# EUROPÄISCHE PATENTSCHRIFT

(11) **EP 1 605 561 B1**
(45) Veröffentlichungstag und Bekanntmachung des Hinweises auf die Patenterteilung: **01.01.2014**
(21) Anmeldenummer: 05000425.8
(22) Anmeldetag: 11.01.2005
(51) Int. Cl.: H01S 5/026, H01S 5/40, H01L 33/00, H01S 5/183

(54) **Strahlungemittierendes Halbleiterbauelement**
Lightemitting semiconductor element
Élement semiconducteur à l'emission de lumière

(30) Priorität: 30.01.2004 DE 102004004781
(43) Veröffentlichungstag der Anmeldung: 14.12.2005
(73) Patentinhaber: OSRAM Opto Semiconductors GmbH, 93055 Regensburg (DE)
(72) Erfinder: Albrecht, Tony, 93077 Bad Abbach (DE); Philippens, Marc, 93049 Regensburg (DE)
(74) Vertreter: Epping - Hermann - Fischer

(56) Entgegenhaltungen:
- EP-A- 0 486 052
- EP-A- 1 249 903

## Beschreibung

Die Erfindung betrifft ein strahlungemittierendes Halbleiterbauelement gemäß dem Oberbegriff des Patentanspruchs 1.

Derartige strahlungemittierende Halbleiterbauelemente können beispielsweise wie in der DE 100 576 98, als zwei oder mehr übereinander angeordnete kantenemittierende Laser ausgeführt werden, wobei die jeweiligen aktiven Zonen im Betrieb kohärente Strahlung der Wellenlänge λ₁ beziehungsweise λ₂ emittieren. Da die Strahlungsleistung kohärenter Strahlung einer bestimmten Wellenlänge im wesentlichen nur entlang einer Hauptabstrahlrichtung abgestrahlt wird, kann ein Beobachter, der das strahlungemittierende Halbleiterbauelement aus einer von der jeweiligen Hauptabstrahlrichtung der Strahlungen der Wellenlänge λ₁ beziehungsweise λ₂ abweichenden Richtung beobachtet oftmals nicht oder nur schwer entscheiden, ob das Halbleiterbauelement zum Beobachtungszeitpunkt Strahlung emittiert oder nicht. Insbesondere gilt dies, falls eine der Wellenlängen λ₁ und λ₂ im nicht sichtbaren Spektralbereich liegt.

Weiterhin ist aus der EP 0 486 052 eine Mehrzahl von übereinander angeordneten aktiven Zonen, die in LED-Strukturen angeordnet sind, bekannt, welche inkohärente Strahlung emittieren. Für Anwendungen, die hohe Intensitäten wie sie mittels Lasern erzeugt werden können erfordern ist ein derartiges Halbleiterbauelement allerdings nicht oder nur unzureichend geeignet. Die inkohärente Strahlung, die von den LED-Chips erzeugt wird, kann allerdings in einem relativ großen Raumwinkelbereich, der die Hauptabstrahlrichtung umfasst, von einem Beobachter erfasst werden. Dieser Raumwinkelbereich kann beispielsweise einen Winkel von 60° oder mehr mit der Hauptabstrahlrichtung des Halbleiterbauelements einschließen.

In der Druckschrift EP 1 249 903 A2 ist ein inkohärente Strahlung emittierendes Bauelement beschrieben, deren erzeugte Strahlung dafür vorgesehen ist, eine aktive Schicht eines Lasers mit vertikaler Kavität optisch zu pumpen und auf diese Weise Laserstrahlung zu erzeugen. Sowohl das inkohärente Strahlung emittierende Bauelement als auch die aktive Schicht sind als organische Schichten beschrieben.

Eine Aufgabe der folgenden Erfindung ist es daher, ein strahlungemittierendes Halbleiterbauelement der oben genannten Art anzugeben, das im Betrieb kohärente Strahlung emittiert und dessen Betriebszustand aus einer von der Hauptabstrahlrichtung der kohärenten Strahlung abweichenden Beobachtungsrichtung ohne besonderen Aufwand erfasst werden kann.

Diese Aufgabe wird durch ein strahlungemittierendes Halbleiterbauelement mit den Merkmalen des vorliegenden Patentanspruchs 1 gelöst.

Ein strahlungemittierendes Halbleiterbauelement gemäß der vorliegenden Erfindung umfasst einen Halbleiterkörper mit einer ersten aktiven Zone und einer der ersten aktiven Zone in vertikaler Richtung nachgeordneten zweiten aktiven Zone, wobei die erste aktive Zone für die Erzeugung einer Strahlung einer ersten Wellenlänge λ₁ vorgesehen ist, die zweite aktive Zone für die Erzeugung einer Strahlung einer zweiten Wellenlänge λ₂ vorgesehen ist und die Strahlung der ersten Wellenlänge λ₁ kohärent sowie die Strahlung der zweiten Wellenlänge λ₂ inkohärent ist.

Es sei angemerkt, dass im Rahmen der Erfindung als kohärente Strahlung im Zweifel Laserstrahlung und als inkohärente Strahlung von einer Laserstrahlung verschiedene mit Halbleitern erzeugbare Strahlung anzusehen ist.

Dies hat den Vorteil, dass die inkohärente Strahlung der Wellenlänge λ₂ verglichen mit der kohärenten Strahlung der Wellenlänge λ₁ gewöhnlich in einem größeren Raumwinkelbereich und abseits der Hauptstrahlrichtung vereinfacht beobachtbar ist. Ist die inkohärente Strahlung bezüglich ihres Betriebszustandes - das Halbleiterbauelement emittiert inkohärente Strahlung oder nicht - an den Betriebszustand der kohärenten Strahlung gekoppelt beziehungsweise ankoppelbar, kann die inkohärente Strahlung als Anzeige des Betriebszustandes der kohärenten Strahlung benutzt werden. Eine direkte Beobachtung der kohärenten Strahlung in Hauptabstrahlrichtung, die beispielsweise aufgrund hoher Intensitäten auf einen menschlichen Beobachter oder im Strahlengang angeordnete Messgeräte schädliche Auswirkungen haben kann, kann dadurch vorteilhaft vermieden werden. Weiterhin kann eine störende Gegenwart eines Beobachters oder eines Messgeräts im Strahlengang vermieden werden.

Der Betriebszustand der inkohärenten und der kohärenten Strahlung bezieht sich im Rahmen der Erfindung auf den entsprechenden Betriebszustand des Halbleiterbauelements, das im jeweiligen Betriebszustand kohärente und/oder inkohärente Strahlung emittieren kann. Die Betriebszustände der kohärenten und der inkohärenten Strahlung können hierbei voneinander unabhängig sein.

Die erste aktive Zone und die zweite aktive Zone sind im Halbleiterkörper monolithisch integriert ausgebildet, der somit in einem durchgehenden Verfahren, wie etwa einem durchgehenden Epitaxieprozess, vorzugsweise auf einem gemeinsamen Aufwachssubstrat, herstellbar ist. Dies hat den Vorteil, dass die Herstellung derartiger Bauelemente vereinfacht erfolgen kann. Die zweite aktive Zone kann in einem Verfahrensschritt mit der ersten aktiven Zone hergestellt werden, wodurch aufwendige nachfolgende Montageschritte zum Anordnen der zweiten aktiven Zone auf der ersten vermieden werden können. Die zweite aktive Zone muss bei der Erfindung nicht nachträglich über der ersten angeordnet werden, da dies schon während der Herstellung des Halbleiterkörpers geschehen kann.

In einer ersten bevorzugten Ausgestaltung der Erfindung ist die erste aktive Zone in einer Halbleiterstruktur ausgebildet, die einen optischen Resonator zur Erzeugung der kohärenten Strahlung umfasst. Eine derartige Halbleiterstruktur kann beispielsweise entsprechend einem kantenemittierenden Laser oder einem Halbleiterbauelement mit vertikaler Emissionsrichtung, wie etwa einem VCSEL (Vertical Cavity Surface Emitting Laser) oder einem VECSEL (Vertical External Cavity Surface Emitting Laser) ausgebildet sein. Die genannten Bauelemente können über induzierte Emission kohärente Strahlung erzeugen, die eine hohe Intensität aufweisen kann.

Die zweite aktive Zone ist bevorzugt in einer LED-Struktur zur Erzeugung inkohärenter Strahlung aus spontaner Emission ausgebildet, die auf bekannte Weise einfach herstellbar ist. Die Produktionskosten für ein Halbleiterbauelement mit einer LED-Struktur und einer Halbleiterstruktur der oben genannten Art können so vorteilhaft gering gehalten werden, wie etwa durch monolithische Integration der LED-Struktur in den Halbleiterkörper, wobei die LED-Struktur auf der Halbleiterstruktur epitaktisch aufgewachsen wird.

Die Halbleiterstruktur enthält weiterhin bevorzugt mindestens ein III-V-Halbleitermaterial, umfassend InₓGa_{y}Al_{1-x-y}P, InₓGa_{y}-Al_{1-x-y}N oder InₓGa_{y}Al_{1-x-y}As, jeweils mit 0≤x≤1, 0≤y≤1 und x+y≤1. Auch die LED-Struktur kann eines dieser Materialien enthalten.

Die zweite aktive Zone ist derart über der ersten aktiven Zone angeordnet, dass die zweite aktive Zone im Strahlengang der Strahlung der Wellenlänge λ₁ angeordnet ist. Um eine nachteilige Absorption der Strahlung der Wellenlänge λ₁ in der zweiten aktiven Zone zu vermeiden, ist λ₁ größer als λ₂, was durch geeignete Ausbildung der jeweiligen aktiven Zonen erreicht werden kann.

Die Wellenlänge λ₂ liegt bevorzugt im sichtbaren Spektralbereich. Dies kann beispielsweise zur visualisierung des Betriebszustandes der kohärenten Strahlung von Vorteil sein. Weiterhin kann die sichtbare inkohärente Strahlung zur Vorjustierung des Strahlengangs beziehungsweise der Hauptabstrahlrichtung der kohärenten Strahlung dienen. Die Vorjustierung der Hauptabstrahlrichtung der kohärenten Strahlung kann insbesondere dann erleichtert werden, wenn die Wellenlänge λ₁ im nicht sichtbaren Spektralbereich liegt. Die Visualisierung und/oder die Vorjustierung der kohärenten Strahlung kann so mit Vorteil über die inkohärente Strahlung und das menschliche Auge erfolgen, so dass zur Vorjustierung auf aufwendige Apparaturen zur Strahlungsdetektion verzichtet werden kann.

Hierzu ist die zweite aktive Zone im Strahlengang der kohärenten Strahlung angeordnet, besonders bevorzugt weist die inkohärente Strahlung in einem Raumwinkelbereich, der die Hauptabstrahlrichtung der kohärenten Strahlung umfasst, eine vergleichsweise hohe oder eine maximale Intensität auf, wodurch eine Vorjustierung der Hauptabstrahlrichtung der kohärenten Strahlung weitergehend erleichtert werden kann. Mit Vorteil können diesbezüglich die beiden aktiven Zonen bereits während der Herstellung des strahlungemittierenden Halbleiterbauelements geeignet ausgebildet werden. Der die erste aktive Zone und die zweite aktive Zone umfassende Halbleiterkörper wird dabei monolithisch integriert hergestellt, wobei die zweite aktive Zone bevorzugt auf der ersten aktiven Zone epitaktisch aufgewachsen wird. Während der Herstellung kann auch die Abstrahlcharakteristik der in zweiten aktiven Zone erzeugbaren Strahlung dahingehend beeinflusst werden, dass diese inkohärente Strahlung im Bereich der Hauptabstrahlrichtung der kohärenten Strahlung eine hohe, vorzugsweise maximale, Intensität aufweist.

In einer weiteren bevorzugten Ausgestaltung der Erfindung sind die erste aktive Zone und die zweite aktive Zone gemeinsam elektrisch ansteuerbar ausgebildet, so dass die Erzeugung der kohärenten Strahlung an die der inkohärenten Strahlung gekoppelt ist. Dies hat den Vorteil, dass der Betriebszustand der kohärenten Strahlung durch den der inkohärenten Strahlung eindeutig bestimmt werden kann beziehungsweise die Betriebszustände miteinander übereinstimmen.

Diese Kopplung kann beispielsweise durch eine Verbindungsschicht erreicht werden, die die erste aktive Zone elektrisch leitend mit der zweiten aktiven Zone verbindet, so dass die beiden aktiven Zonen des Bauelements in Serie geschaltet angeschlossen werden können. Die Verbindungsschicht umfasst bevorzugt einen Tunnelübergang, der besonders bevorzugt während der Herstellung des Halbleiterbauelements monolithisch in den Halbleiterkörper integriert wird. Ein derartiger Tunnelübergang ist vorzugsweise zwischen der ersten und der zweiten aktiven Zone angeordnet und/oder enthält mindestens eine Schicht, die eine höhere Ladungsträgerkonzentration, beispielsweise durch hohe Dotierung, aufweist, als eine angrenzende Schicht des gleichen Leitungstyps (p-leitend oder n-leitend). Weiterhin weist das Halbleiterbauelement bevorzugt gemeinsame elektrische Anschlüsse für die beiden aktiven Zonen auf, mittels derer die aktiven Zonen gemeinsam angesteuert werden. Tunnelübergange sind in der DE 100 576 98 beschrieben.

In einer weiteren bevorzugten Ausgestaltung der Erfindung sind die erste aktive Zone und die zweite aktive Zone getrennt voneinander elektrisch ansteuerbar ausgebildet, so dass die Betriebszustände der kohärenten Strahlung und der inkohärenten Strahlung voneinander entkoppelt sein können. Das Halbleiterbauelement kann somit Strahlung mit den Wellenlängen λ₁ und/oder λ₂ emittieren. Dies ist von Vorteil, falls beispielsweise die inkohärente Strahlung während des Betriebs des strahlungemittierenden Halbleiterbauelements abgeschaltet werden soll, etwa um nachteilige Einflüsse dieser Strahlung auf Messungen zu vermeiden. Weiterhin kann ein derartiges Halbleiterbauelement auch derart angesteuert werden, dass nur inkohärente Strahlung emittiert wird, zu der die kohärente Strahlung zugeschaltet werden kann.

Dies kann beispielsweise durch eine Verbindungsschicht erreicht werden, die bevorzugt zwischen den beiden aktiven Zo-nen angeordnet ist und/oder die erste aktive Zone im wesentlichen elektrisch von der zweiten aktiven Zone isoliert. Bevorzugt ist hierzu in der Verbindungsschicht ein Barrierenübergang ausgebildet, der im Betrieb des Bauelements Stromfluss durch die Barriere zumindest stark verringert, wie beispielsweise ein sperrender pn-Übergang. Der Barriereübergang wird besonders bevorzugt während der Herstellung des Halbleiterbauelements monolithisch in den Halbleiterkörper integriert. Mit Vorteil wird der Barriereübergang bereits bei der Herstellung des Halbleiterkörpers ausgebildet und es müssen keine zusätzlichen Schichten zur Ausbildung des Barriereübergangs im Halbleiterkörper hergestellt werden.

Weiterhin weist das Halbleiterbauelement bei dieser Ausgestaltung bevorzugt separate elektrische Anschlüsse für die beiden aktiven Zonen auf, um deren getrennte Ansteuerung zu ermöglichen.

Weitere Merkmale, Vorteile und Zweckmäßigkeiten der Erfindung ergeben sich aus den Beschreibungen der folgenden Ausführungsbeispiele in Verbindung mit den folgenden Figuren.

Es zeigen
- Figur 1: eine schematische Schnittansicht eines ersten Ausführungsbeispiels eines erfindungsgemäßen strahlungemittierenden Halbleiterbauelements.
- Figur 2: eine schematische Schnittansicht eines zweiten Ausführungsbeispiels eines erfindungsgemäßen strahlungemittierenden Halbleiterbauelements.

Gleichartige und gleich wirkende Elemente sind in den Figuren mit den gleichen Bezugszeichen versehen.

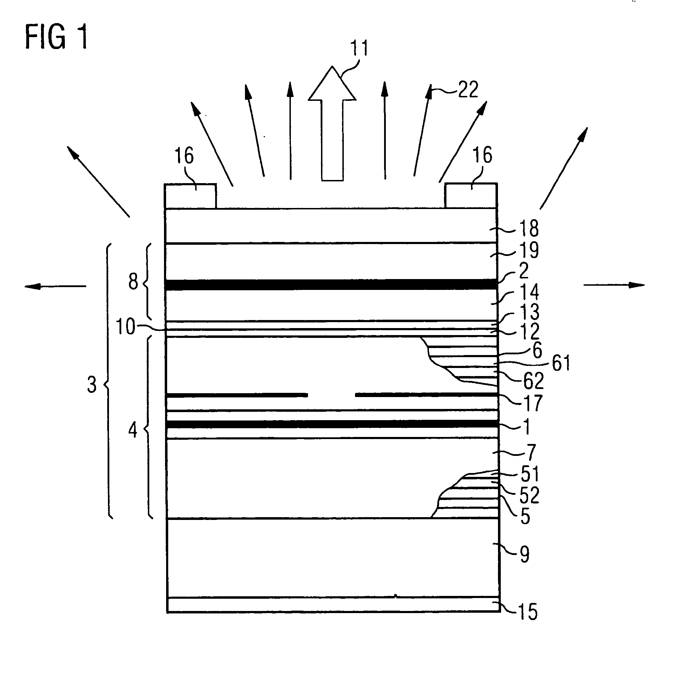

In der Figur 1 ist eine schematische Schnittansicht eines ersten Ausführungsbeispiels eines erfindungsgemäßen strahlungemittierenden Halbleiterbauelements dargestellt.

Ein Halbleiterkörper 3 umfasst eine erste aktive Zone 1 und eine zweite aktive Zone 2, wobei die erste aktive Zone kohärente Strahlung 11 einer Wellenlänge λ₁ und die zweite aktive Zone inkohärente Strahlung 22 einer Wellenlänge λ₂ erzeugt. Die erste aktive Zone 1 ist in diesem Ausführungsbeispiel in einer Laserstruktur 4 ausgebildet, die einem VCSEL entspricht. Ein erster, vorzugsweise n-leitender, Spiegel 5 und ein zweiter, vorzugsweise p-leitender, Spiegel 6, die beispielsweise jeweils als Braggspiegel ausgebildet sind und eine Mehrzahl von schematisch dargestellten Halbleiterschichtenpaaren 51,52 beziehungsweise 61,62 unterschiedlicher Brechungsindices aufweisen, bilden einen optischen Resonator 7 für die in der ersten aktiven Zone erzeugte Strahlung 11. Die Reflektivität des ersten Spiegels 5 ist bevorzugt größer als die des zweiten Spiegels 6, der als Auskoppelspiegel der Strahlung 11 aus der Laserstruktur 4 dient. Für VCSEL typische Reflektivitäten der Resonatorspiegel können bei über 98% liegen.

Die zweite aktive Zone 2 ist in einer LED-Struktur 8 angeordnet. Die Wellenlänge λ₁ ist bevorzugt größer als die Wellenlänge λ₂, um eine nachteilige Absorption der Strahlung der Wellenlänge λ₁ in der zweiten aktiven Zone 2 zu vermeiden. Besonders bevorzugt liegt λ₁ im nicht sichtbaren Spektralbereich, sondern beispielsweise dem infraroten Bereich, und die Wellenlänge λ₂ liegt besonders bevorzugt im sichtbaren, beispielsweise dem gelben bis roten Spektralbereich.

Derartige Wellenlängen können beispielsweise im Materialsystem InₓGa_{y}Al_{1-x-y}P oder InₓGa_{y}Al_{1-x-y}As, jeweils mit 0≤x≤1, 0≤y≤1 und x+y≤1 realisiert werden, auf dem die LED-Struktur 8 und/oder die Laserstruktur 4 bevorzugt basieren.

Die LED-Struktur 8 ist epitaktisch auf der Laserstruktur 4 gewachsen, welche wiederum epitaktisch auf einem Aufwachssubstrat 9, beispielsweise n-leitendes GaAs enthaltend, hergestellt ist. Der Halbleiterkörper 3 ist somit monolithisch integriert ausgebildet.

Die Hauptabstrahlrichtung der kohärenten Strahlung ist in der Figur 1 durch den Pfeil 11 und die Abstrahlrichtungen der inkohärenten Strahlung durch die Pfeile 22 dargestellt. Die inkohärente Strahlung strahlt in einen größeren Raumwinkelbereich ab als die kohärente Strahlung und ist somit in einem Raumwinkelbereich, außerhalb der Hauptabstrahlrichtung der kohärenten Strahlung 11 verglichen mit dieser vereinfacht detektierbar. Insbesondere wird die inkohärente Strahlung, wie aus der Figur 1 ersichtlich, auch in lateraler Richtung emittiert. Im Bereich um die Hauptabstrahlrichtung der kohärenten Strahlung 11 weist die inkohärente Strahlung 22 mit Vorteil eine hohe Intensität auf, um die Vorjustierung der Hauptabstrahlrichtung der kohärenten Strahlung 11 zu erleichtern. Dies kann mit besonderem Vorteil bereits während der Herstellung des monolithisch integrierten Halbleiterkörpers realisiert werden.

Die Laserstruktur 4 ist seitens des zweiten Spiegels 6 mit der LED-Struktur 8 über eine Verbindungsschicht 10, die vorzugsweise einen Tunnelübergang enthält, elektrisch leitend verbunden. Der Tunnelübergang umfasst bevorzugt mindestens zwei Halbleiterschichten 12, 13 unterschiedlicher Leitungstypen. Seitens der ersten aktiven Zone 1 ist in diesem Ausführungsbeispiel eine p-leitende Schicht 12 angeordnet, die eine höhere Ladungsträgerkonzentration (p⁺) aufweist als die auf der Seite der ersten aktiven Zone angrenzende Schicht, die hier durch den p-leitenden zweiten Spiegel 5 gegeben ist. Seitens der zweiten aktiven Zone 2 ist eine n-leitende Schicht 13 angeordnet, die durch hohe Dotierung eine höhere Ladungsträgerkonzentration (n⁺) aufweist als eine seitens der LED-Struktur 8 an diese angrenzende n-leitende Schicht, die hier beispielsweise durch eine in der LED-Struktur ausgebildete n-leitende Wellenleiterschicht 14 gegeben ist. Ein derartiger Tunnelübergang ist mit Vorzug monolithisch im Halbleiterkörper integriert ausgebildet.

Die LED-Struktur 8 und die Laserstruktur 4 sind über den Tunnelübergang 10 elektrisch leitend verbunden. Die erste und die zweite aktive Zone können über einen n-Kontakt 15 und einen p-Kontakt 16 als in Serie geschaltet betrieben werden. Die aktiven Zonen 1,2 sind über die Kontakte 15, 16 gemeinsam ansteuerbar und die Betriebszustände der kohärenten Strahlung 11 und der inkohärenten Strahlung 22 stimmen überein, so dass das Bauelement im regulären Betrieb sowohl inkohärente als auch kohärente Strahlung emittiert. Die inkohärente Strahlung ist an den Betriebszustand der kohärenten Strahlung gekoppelt und kann als Kontrolle für diesen eingesetzt werden. Besonders bevorzugt liegt hierbei die Wellenlänge λ₂ im roten Spektralbereich, da sich rotes Licht durch eine hohe Signalwirkung, insbesondere auf einen menschliche Beobachter, auszeichnet und deshalb für die Anzeige einer vorhandenen kohärenten, beispielsweise infraroten, Laserstrahlung besonders geeignet ist.

Die sichtbare Strahlung erzeugende LED-Struktur kann demnach als Kontroll-LED für den Betriebszustand einer nichtsichtbaren Laserstrahlung, beispielsweise der eines Infrarot-Lasers, verwendet werden, wobei sowohl die Kontroll-LED als auch der Laser in einem Halbleiterkörper oder Halbleiterchip monolithisch integriert werden können. Während der Herstellung des Halbleiterkörpers kann auch die Abstrahlcharakteristik der LED-Struktur beeinflusst werden. Eine Kontroll-LED wird auch in herkömmlichen Vorrichtungen an den Betriebszustand einer nicht sichtbaren Laserstrahlung gekoppelt. Diese Kontroll-LED ist allerdings nicht mit dem Laser in einem gemeinsamen Halbleiterkörper ausgebildet, sondern außerhalb der Laserstruktur angeordnet. Zu Vorjustagezwecken muss die Abstrahlcharakteristik einer derartigen Kontroll-LED aufwendig auf die der Laserstrahlung abgestimmt werden. Dies kann bei der Erfindung mit Vorteil jedoch schon während der Herstellung des Halbleiterkörpers geschehen.

Um die Strahlungserzeugung in der ersten aktiven Zone möglichst effektiv zu gestalten, ist in der Laserstruktur 4, vorzugsweise im zweiten Spiegel 6, eine Stromeinschnürungsschicht 17 angeordnet, die den zur Strahlungserzeugung vorgesehenen Bereich der ersten aktiven Zone bestimmt. Eine Öffnung in der Stromeinschnürungsschicht 17, die über dem zur Strahlungserzeugung vorgesehenen Bereich der aktiven Zone angeordnet ist bestimmt diesen Bereich. Die Stromeinschnürungsschicht 17 kann beispielsweise über gezielte Oxidation eines in der Laserstruktur vorhandenen Materials erzeugt werden. Hierzu kann beispielsweise der Anteil von leicht oxidierendem Material in der Laserstruktur, wie etwa Al, im Bereich, in dem die Stromeinschnürungsschicht vorgesehen werden soll, verglichen mit der übrigen Laserstruktur derart erhöht werden, dass eine Oxidation in diesem Bereich erleichtert wird, die zur Ausbildung einer Stromeinschnürungsschicht der in Figur 1 dargestellten Art führen kann. Die Stromeinschnürungsschicht weist bevorzugt eine verglichen mit der restlichen Laserstruktur geringere Leitfähigkeit auf, so dass die Strahlungserzeugung im wesentlich in dem Bereich der ersten aktiven Zone erfolgt, der unter der Öffnung angeordnet ist erfolgt. Insbesondere wird dadurch weniger Strahlung in den lateralen Randbereichen der ersten aktiven Zone erzeugt und mit Vorteil die Erzeugung kohärenter Strahlung in der ersten aktiven Zone erleichtert beziehungsweise effizienter gestaltet.

Der p-Kontakt 16 weist im mittleren Bereich eine Aussparung auf um eine Absorption der von den aktiven Zonen erzeugten Strahlungen im Material des p-Kontaktes zu vermeiden. Beispielsweise enthält der p-Kontakt ebenso wie der n-Kontakt 15 ein Metall, etwa Au. Eine auf einer p-leitenden Wellenleiterschicht 19 der LED-Struktur 8 angeordnete Stromaufweitungsschicht 18 sorgt für eine homogene Stromeinprägung vom p-Kontakt 16 in die zweite aktive Zone 2. Mit Vorteil wird so die Effizienz der Strahlungserzeugung, insbesondere in der zweiten aktiven Zone, gesteigert.

Diese Stromaufweitungsschicht ist bevorzugt strahlungsdurchlässig ausgebildet. Besonders bevorzugt enthält die Stromaufweitungsschicht ein TCO-Material (Transparent Conducting Oxide), wie beispielsweise ZnO, ein ITO, oder ähnliche Materialien. TCO-Materialien zeichnen sich durch hohe Strahlungsdurchlässigkeit über einen weiten Wellenlängenbereich bei gleichzeitig hoher elektrischer Leitfähigkeit, insbesondere in lateraler Richtung, aus. ZnO beispielsweise ist für den elektrischen Kontakt zu p-leitendem Material, insbesondere ein Halbleitermaterial aus dem Materialsystem InₓGa_{y}Al_{1-x-y}P enthaltend, besonders geeignet und kann zu p-leitendem Material einen, vorzugsweise ohmschen, elektrischen Kontakt ausbilden.

Die Wellenleiterschichten 14 und 19 sind bevorzugt so ausgebildet, dass sie die in der zweiten aktiven Zone erzeugte Strahlung 22, insbesondere auch in lateraler Richtung, derart führen, dass ein möglichst geringer Anteil dieser Strahlung in Richtung der ersten aktiven Zone abgestrahlt wird. Dadurch wird die Absorption der inkohärenten Strahlung der Wellenlänge λ₂ in der ersten aktiven Zone vorteilhaft verringert. Besonders bevorzugt wird die inkohärente Strahlung so auch vermehrt in horizontaler oder lateraler Richtung - im wesentlichen senkrecht zur vertikalen Hauptabstrahlrichtung der kohärenten Laserstrahlung 11 aus der Laserstruktur 4 - emittiert und somit der Raumwinkelbereich, in dem die inkohärente Strahlung von einem Beobachter vereinfacht erfasst werden kann, vorteilhaft vergrößert.

Soll die LED-Struktur zur Vorjustage der Hauptabstrahlrichtung der kohärenten Strahlung verwendet werden, so kann auf die Wellenleiterschichten verzichtet werden, um die Intensität der inkohärenten Strahlung entlang der Hauptabstrahlrichtung der kohärenten Strahlung nicht unnötig auf Kosten der Intensität in lateraler Richtung abzuschwächen.

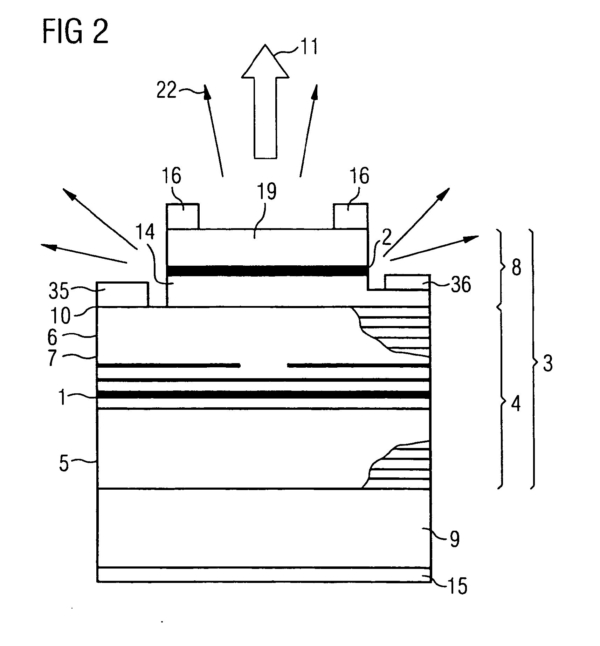

In der Figur 2 ist eine schematische Schnittansicht eines zweiten Ausführungsbeispiels eines erfindungsgemäßen strahlungemittierenden Halbleiterbauelements dargestellt.

Das in Figur 2 gezeigte strahlungemittierende Halbleiterbauelement entspricht im wesentlichen dem in Figur 1 dargestellten Halbleiterbauelement.

Der Halbleiterkörper 3 umfasst eine Laserstruktur 4, die gemäß einem VCSEL mit einem von den n- beziehungsweise p-leitenden Spiegeln 5 und 6 gebildeten optischen Resonator 7 ausgebildet ist. In der Laserstruktur ist eine erste aktive Zone 1 ausgebildet, die kohärente Strahlung 11 der Wellenlänge λ₁ in vertikaler Richtung erzeugen kann. Über der Laserstruktur in einer LED-Struktur 8 eine zweite aktive Zone 2 angeordnet, die inkohärente Strahlung 22 der Wellenlänge λ₂ erzeugen kann, die in einem verglichen mit der Hauptstrahlrichtung der kohärenten Strahlung größeren Raumwinkelbereich abgestrahlt wird. Von der LED-Struktur 8 umfasste n- beziehungsweise p-leitende Wellenleiterschichten 14 und 19 führen die inkohärente Strahlung vermehrt in die laterale Richtung. Der Halbleiterkörper 3, der die LED-Struktur und die Laserstruktur umfasst, ist bevorzugt durch epitaktisches Aufwachsen monolithisch integriert ausgebildet. Die Laserstruktur 4 wird zunächst epitaktisch auf dem Aufwachssubstrat 9 gewachsen. Nachfolgend kann die LED-Struktur epitaktisch auf der Laserstruktur gewachsen werden.

Im Unterschied zu dem in Figur 1 dargestellten Halbleiterbauelement weist das in Figur 2 gezeigte Halbleiterbauelement getrennte Anschlüsse zur Kontaktierung der ersten aktiven Zone und der zweiten aktiven Zone auf. Die erste aktive Zone 1 ist über den auf dem zweiten Spiegel 6 angeordneten p-Kontakt 35 und den n-Kontakt 15 elektrisch anschließbar während die zweite aktive Zone 2 über den p-Kontakt 16 und den n-Kontakt 36 elektrisch anschließbar ist.

Die LED-Struktur 8 ist mit der Laserstruktur 4 über eine Verbindungsschicht 10 verbunden, die einen Barrierenübergang umfasst, der in diesem Ausführungsbeispiel als pn-Übergang zwischen dem p-leitenden zweiten Spiegel 6 und der n-leitenden Wellenleiterschicht 14 ausgeführt ist und/oder anderweitig monolithisch im Halbleiterkörper 3 integriert werden kann. Der Barrierenübergang sperrt bezüglich einer gemeinsamen Kontaktierung der beiden aktiven Zonen über die Kontakte 15 und 16, so dass eine gemeinsame Kontaktierung wie in Figur 1 zumindest erheblich erschwert und eine getrennte Ansteuerung der ersten und der zweiten aktiven Zone ermöglicht wird.

Die zweite aktive Zone hat in diesem Ausführungsbeispiel eine geringere laterale Ausdehnung als die erste aktive Zone, so dass mit Vorteil die Ausbildung der Kontakte 35 und 36 auf dem zweiten Spiegel 6 beziehungsweise dem Wellenleiter 14 ermöglicht beziehungsweise erleichtert wird. Zwischen der LED-Struktur 8 und dem p-Kontakt 35 der Laserstruktur 4 ist bevorzugt ein Zwischenraum in lateraler Richtung vorgesehen, der einem Kurzschluß vorbeugt. Der n-Kontakt 36 der LED-Struktur-8 ist auf einem Vorsprung angeordnet, den der n-leitende Wellenleiter 14 aufweist, wobei der Wellenleiter 14 eine laterale Ausdehnung besitzt, die mit Vorteil größer als die der zweiten aktiven Zone aber kleiner als die der ersten aktiven Zone ist.

Eine derartige Strukturierung des Halbleiterkörpers 3, insbesondere der LED-Struktur 8, kann beispielsweise über Maskierungs- und Ätzprozesse erfolgen. Die Strukturierung kann mit Vorteil nach einer monolithisch integrierten Ausbildung des Halbleiterkörpers durchgeführt werden.

Die zweite aktive Zone in der LED-Struktur und die erste aktive Zone in der Laserstruktur können somit in diesem Ausführungsbeispiel separat betrieben werden, weshalb das strahlungemittierende Halbleiterbauelement Strahlung mit den Wellenlängen λ₁ und/oder λ₂ emittieren kann, deren Erzeugung über separate Anschlüsse gesteuert werden kann.

Abweichend von den in den Figuren 1 und 2 dargestellten Ausführungsbeispielen können die erste aktive Zone und die zweite aktive Zone auch über einen gemeinsamen n-Kontakt und separate p-Kontakte angesteuert werden. Dies entspricht der in Figur 2 dargestellten Kontaktstruktur unter Verzicht auf den n-Kontakt 36. Die Verbindungsschicht verbindet die aktiven Zonen in diesem Falle, bevorzugt über einen Tunnelübergang wie in Figur 1, elektrisch leitend. Das so gebildete strahlungemittierende Halbleiterbauelement emittiert im Betrieb kohärente Strahlung zu der die inkohärente Strahlung zugeschaltet werden kann. Die Zuschaltung kann über die separaten p-Kontakte für die erste und die zweite aktive Zone erfolgen. Wird p-seitig über den p-Kontakt 16 der LED-Struktur kontaktiert, so emittiert das Bauelement sowohl kohärente als auch inkohärente Strahlung, während bei p-seitiger Kontaktierung über den p-Kontakt 35 der Laserstruktur 4 nur kohärente Strahlung erzeugt wird.

Es sei angemerkt, dass das Aufwachssubstrat 9 der Laserstruktur 4 auch während der Herstellung des Halbleiterbauelements oder des Halbleiterkörpers abgelöst und durch einen geeigneten Träger ersetzt werden kann. Dieser weist mit Vorteil eine hohe Wärmeleitfähigkeit zur Ableitung der im Halbleiterkörper entstehenden Wärme und/oder eine hohe elektrische Leitfähigkeit zur elektrische Kontaktierung des Halbleiterkörpers über den Träger auf.

Diese Patentanmeldung beansprucht die Priorität der deutschen Patentanmeldung 10 2004 004 781.2 vom 30. Januar 2004, deren Offenbarungsgehalt hiermit explizit durch Rückbezug in die vorliegende Anmeldung aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Strahlungemittierendes Halbleiterbauelement, umfassend einen Halbleiterkörper (3) mit einer ersten aktiven Zone (1) und einer der ersten aktiven Zone in vertikaler Richtung nachgeordneten zweiten aktiven Zone (2), wobei die erste aktive Zone für die Erzeugung einer Strahlung einer ersten Wellenlänge λ₁ (11) und die zweite aktive Zone für die Erzeugung einer Strahlung einer zweiten Wellenlänge λ₂ (22) vorgesehen ist, und die Strahlung der ersten Wellenlänge λ₁ kohärent und die der zweiten Wellenlänge λ₂ inkohärent ist,
wobei
- die erste aktive Zone und die zweite aktive Zone monolithisch in den Halbleiterkörper integriert sind;
- die erste und die zweite aktive Zone elektrisch ansteuerbar ausgebildet sind;
- die zweite aktive Zone im Strahlengang der Strahlung der Wellenlänge λ₁ angeordnet ist; und
- die Wellenlänge λ₁ größer ist als die Wellenlänge λ₂.

2. Strahlungemittierendes Halbleiterbauelement nach Anspruch 1,
**dadurch gekennzeichnet, dass**
die Wellenlänge λ₁ im nicht sichtbaren Spektralbereich liegt.

3. Strahlungemittierendes Halbleiterbauelement nach Anspruch 1 oder 2,
**dadurch gekennzeichnet, dass**
die Wellenlänge λ₂ im sichtbaren Spektralbereich liegt.

4. Strahlungemittierendes Halbleiterbauelement nach einem der vorhergehenden Ansprüche,
**dadurch gekennzeichnet, dass**
die erste aktive Zone in einer Halbleiterstruktur (4) ausgebildet ist, die einen optischen Resonator (7) umfasst.

5. Strahlungemittierendes Halbleiterbauelement nach Anspruch 4,
**dadurch gekennzeichnet, dass**
die Halbleiterstruktur entsprechend einem Halbleiterbauelement mit vertikaler Emissionsrichtung, insbesondere einem vertikalemittierenden Laser, ausgebildet ist.

6. Strahlungemittierendes Halbleiterbauelement nach einem der vorhergehenden Ansprüche,
**dadurch gekennzeichnet, dass**
die zweite aktive Zone in einer LED-Struktur (8) ausgebildet ist.

7. Strahlungemittierendes Halbleiterbauelement nach Anspruch 6,
**dadurch gekennzeichnet, dass** die erste aktive Zone in einer Halbleiterstruktur(4) ausgebildet ist, die einen optischen Resonator (7) umfasst; und
die LED-Struktur mit der Halbleiterstruktur über eine Verbindungsschicht (10) verbunden ist.

8. Strahlungemittierendes Halbleiterbauelement nach Anspruch 7,
**dadurch gekennzeichnet, dass**
die Verbindungsschicht einen Tunnelübergang (12,13) umfasst, der die LED-Struktur und die Halbleiterstruktur elektrisch leitend verbindet.

9. Strahlungemittierendes Halbleiterbauelement nach einem der vorhergehenden Ansprüche,
**dadurch gekennzeichnet, dass**
die erste und die zweite aktive Zone gemeinsam elektrisch ansteuerbar ausgebildet sind.

10. Strahlungemittierendes Halbleiterbauelement nach Anspruch 7,
**dadurch gekennzeichnet, dass**
die Verbindungsschicht einen Barriereübergang umfasst, der die LED-Struktur von der Halbleiterstruktur elektrisch isoliert.

11. Strahlungemittierendes Halbleiterbauelement nach einem der vorhergehenden Ansprüche,
**dadurch gekennzeichnet, dass**
die erste und die zweite aktive Zone getrennt voneinander elektrisch ansteuerbar ausgebildet sind.

## Claims

1. Radiation-emitting semiconductor component, comprising a semiconductor body (3) with a first active zone (1) and a second active zone (2) arranged downstream of the first active zone in a vertical direction, the first active zone being provided for generating a radiation having a first wavelength λ₁ (11) and the second active zone being provided for generating a radiation having a second wavelength λ₂ (22), and the radiation having the first wavelength λ₁ being coherent and the radiation having the second wavelength λ₂ being incoherent,
- the first active zone and the second active zone being monolithically integrated into the semiconductor body;
- the first and second active zones being formed such that they are electrically drivable;
- the second active zone being arranged in the beam path of the radiation having the wavelength λ₁; and
- the wavelength λ₁ being greater than the wavelength λ₂.

2. Radiation-emitting semiconductor component according to Claim 1,
**characterized in that**
the wavelength λ₁ lies in the non-visible spectral range.

3. Radiation-emitting semiconductor component according to Claim 1 or 2,
**characterized in that**
the wavelength λ₂ lies in the visible spectral range.

4. Radiation-emitting semiconductor component according to one of the preceding claims, **characterized in that**
the first active zone is formed in a semiconductor structure (4) comprising an optical resonator (7).

5. Radiation-emitting semiconductor component according to Claim 4,
**characterized in that**
the semiconductor structure is formed in accordance with a semiconductor component with a vertical emission direction, in particular a vertically emitting laser.

6. Radiation-emitting semiconductor component according to one of the preceding claims,
**characterized in that**
the second active zone is formed in an LED structure (8).

7. Radiation-emitting semiconductor component according to Claim 6,
**characterized in that**
the first active zone is formed in a semiconductor structure (4) comprising an optical resonator (7); and
the LED structure is connected to the semiconductor structure via a connecting layer (10).

8. Radiation-emitting semiconductor component according to Claim 7,
**characterized in that**
the connecting layer comprises a tunnel junction (12, 13) that electrically conductively connects the LED structure and the semiconductor structure.

9. Radiation-emitting semiconductor component according to one of the preceding claims,
**characterized in that**
the first and second active zones are formed such that they are jointly electrically drivable.

10. Radiation-emitting semiconductor component according to Claim 7,
**characterized in that**
the connecting layer comprises a barrier junction that electrically insulates the LED structure from the semiconductor structure.

11. Radiation-emitting semiconductor component according to one of the preceding claims,
**characterized in that**
the first and second active zones are formed such that they are electrically drivable separately from one another.

## Revendications

1. Elément semi-conducteur émettant un rayonnement, comprenant un corps semi-conducteur (3) doté d'une première zone active (1) et d'une deuxième zone active (2) disposée en aval de la première zone active dans une direction verticale,
la première zone active étant prévue pour former un rayonnement d'une première longueur d'onde λ₁ (11) et la deuxième zone active pour former un rayonnement d'une deuxième longueur d'onde λ₂ (22), le rayonnement de la première longueur d'onde λ₁ étant cohérent et celui de la deuxième longueur d'onde λ₂ étant non cohérent,
la première zone active et la deuxième zone active étant intégrées monolithiquement dans le corps semi-conducteur,
la première et la deuxième zone active étant configurées de manière à pouvoir être commandées électriquement,
la deuxième zone active étant disposée dans le parcours des rayons du rayonnement de la longueur d'onde λ₁ et
la longueur d'onde λ₁ étant supérieure à la longueur d'onde λ₂.

2. Elément semi-conducteur émettant un rayonnement selon la revendication 1, **caractérisé en ce que** la longueur d'onde λ₁ est située dans la partie non visible du spectre.

3. Elément semi-conducteur émettant un rayonnement selon les revendications 1 ou 2, **caractérisé en ce que** la longueur d'onde λ₂ est située dans la partie visible du spectre.

4. Elément semi-conducteur émettant un rayonnement selon l'une des revendications précédentes, **caractérisé en ce que** la première zone active est formée dans une structure semi-conductrice (4) qui comporte un résonateur optique (7).

5. Elément semi-conducteur émettant un rayonnement selon la revendication 4, **caractérisé en ce que** la structure semi-conductrice est formée en correspondance à un élément semi-conducteur présentant une direction verticale d'émission et en particulier dans un laser émettant verticalement.

6. Elément semi-conducteur émettant un rayonnement selon l'une des revendications précédentes, **caractérisé en ce que** la deuxième zone active est configurée en structure LED (8).

7. Elément semi-conducteur émettant un rayonnement selon la revendication 6, **caractérisé en ce que** la première zone active est configurée en structure semi-conductrice (4) qui comporte un résonateur optique (7) et **en ce que** la structure LED est reliée à la structure semi-conductrice par une couche de liaison (10).

8. Elément semi-conducteur émettant un rayonnement selon la revendication 7, **caractérisé en ce que** la couche de liaison comporte une transition tunnel (12, 13) qui relie de manière électriquement conductrice la structure LED et la structure semi-conductrice.

9. Elément semi-conducteur émettant un rayonnement selon l'une des revendications précédentes, **caractérisé en ce que** la première et la deuxième zone active sont configurées de manière à pouvoir être commandées électriquement de manière conjointe.

10. Elément semi-conducteur émettant un rayonnement selon la revendication 7, **caractérisé en ce que** la couche de liaison comporte une transition de barrière qui isole électriquement la structure LED de la structure semi-conductrice.

11. Elément semi-conducteur émettant un rayonnement selon l'une des revendications précédentes, **caractérisé en ce que** la première et la deuxième zone active sont configurées de manière à pouvoir être commandées électriquement de manière séparée l'une de l'autre.
